# FASCICULE DE BREVET EUROPEEN

(11) **EP 0 490 727 B1**
(45) Date de publication et mention de la délivrance du brevet: **25.01.1995**
(21) Numéro de dépôt: 91403232.1
(22) Date de dépôt: 29.11.1991
(51) Int. Cl.: C23C 14/24, C23C 14/52, C30B 30/08, C30B 23/02

(54) **Appareil et creuset pour dépot en phase vapeur**
Vorrichtung und Tiegel zur Abscheidung aus der Gasphase
Apparatus and crucible for vapor phase deposition

(30) Priorité: 07.12.1990 FR 9015368
(43) Date de publication de la demande: 17.06.1992
(73) Titulaire: SOCIETE EUROPEENNE DE PROPULSION, 92150 Suresnes (FR)
(72) Inventeur: Valentian, Dominique, F-78170 Rosny S/Seine (FR)
(74) Mandataire: Thévenet, Jean-Bruno

(56) Documents cités:
- AU-B- 485 215
- DE-B- 1 112 044
- PATENT ABSTRACTS OF JAPAN vol. 11, no. 381 (C-464)(2828) 12 Décembre 1987; & JP-A-62 153 192

## Description

### Domaine de l'invention

D'une manière générale, l'invention concerne les techniques de dépôt en phase vapeur à haute température, de l'ordre de 900°C par exemple, mises en oeuvre aussi bien dans l'espace, en état d'apesanteur, que sur terre. De telles techniques de dépôt en phase vapeur exigent le maintien de profils de température avec une très grande précision pour réaliser des expériences de thermodiffusion, thermomigration, croissance de cristaux ou encore dépôts par épitaxie.

De façon plus particulière, l'invention concerne un creuset pour dépôt en phase vapeur à haute température comprenant une enceinte fermée avec plusieurs compartiments définissant des zones isothermes successives et dans lesquels sont placés d'une part un matériau source de vapeur et d'autre part un substrat receveur de vapeur.

L'invention concerne encore un appareil pour dépôt en phase vapeur à haute température comprenant une enceinte isolante thermiquement, et des diffuseurs destinés à produire des zones de chauffage isotherme dans des compartiments successifs d'un creuset fermé amovible destiné à contenir d'une part un matériau source de vapeur et d'autre part un substrat receveur de vapeur.

### Art antérieur

Les fours destinés à la diffusion en phase vapeur ou à la croissance cristalline en phase vapeur sont formés de deux ou trois zones isothermes permettant le transfert d'une zone chaude (source) vers une zone de dépôt et éventuellement une zone plus froide (puits).

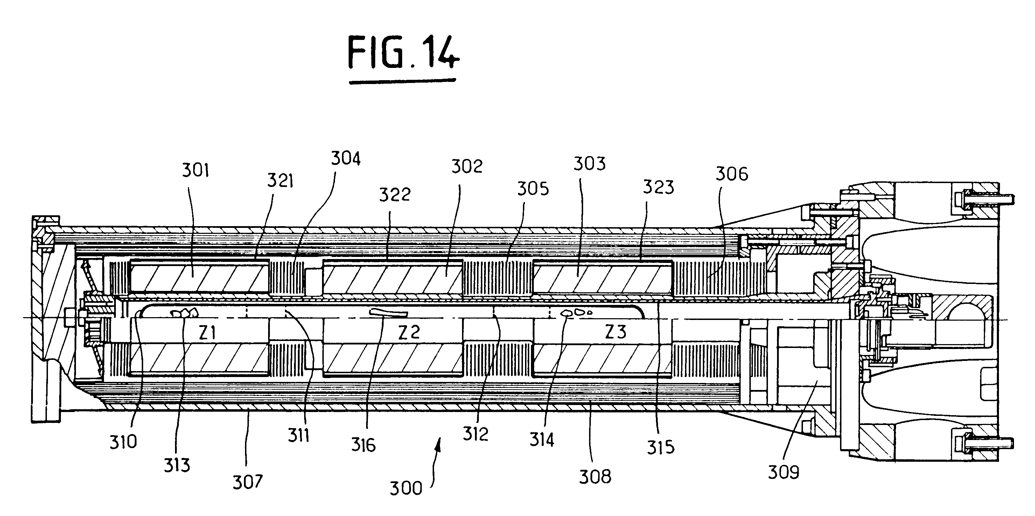

On connait notamment un four multizone 300, illustré sur la fig. 14, qui comprend trois zones isothermes Z1, Z2, Z3 colinéaires. Dans ce cas, la cartouche 315, dans laquelle est disposée l'ampoule 310 contenant le matériau source 313 et le substrat 316 sur lequel s'effectue un dépôt en phase vapeur, est rectiligne, présente une forme essentiellement cylindrique et se trouve placée à l'intérieur d'un corps métallique également cylindrique 307 muni d'un garnissage superisolant 308 et comportant trois blocs diffuseurs 301, 302, 303 munis d'éléments chauffants 321, 322,323, séparés entre eux par des dispositifs superisolants 304, 305, 306 et étagés le long du four pour créer une première zone isotherme source Z1, une deuxième zone isotherme de dépôt Z2 et une troisième zone isotherme Z3 formant puits de chaleur, un puits thermique 309 plus accentué étant en outre prévu à la suite de la troisième zone isotherme Z3. L'ampoule 310 comprend elle-même un premier compartiment situé dans la première zone isotherme Z1 et dans lequel sont placés des cristaux du matériau source qui est à déposer en phase vapeur sur un substrat receveur du dépôt lui-même disposé dans un deuxième compartiment central situé dans la deuxième zone isotherme. Des cristaux 314 peuvent en outre être placés le cas échéant dans un troisième compartiment situé dans la troisième zone isotherme et qui constitue un puits de chaleur. Des grilles 311, 312 laissant passer la vapeur séparent les différents compartiments de l'ampoule 310. A titre d'exemple, les zones isothermes Z1, Z2, Z3 peuvent présenter des températures respectivement de 810°C, 805°C et 797°C et le puits thermique supplémentaire 309 situé au-delà de l'ampoule 310 peut lui-même présenter une température de l'ordre de 100°C.

Le four multizone tel que celui représenté sur la fig.14 présente plusieurs inconvénients liés à sa structure.

En particulier, dans le cas d'expériences devant avoir lieu en microgravité lors de missions dans l'espace à bord de navettes spatiales par exemple, il n'est possible de traiter qu'une seule cartouche par vol, la cartouche 315 étant installée dans le four 300 avant le départ puis extraite au retour. Il n'est ainsi pas possible d'effectuer un échange automatique de cartouches (creusets) au cours d'un même vol.

La configuration du four avec trois zones de chauffage successives colinéaires conduit à un encombrement important. A titre d'exemple, la partie chaude d'un four multizone tel que celui de la fig. 14 peut présenter un diamètre de l'ordre de 60mm et une longueur supérieure à 450mm.

La longueur du creuset 315 rend très difficile un examen optique de la zone centrale.

De plus, les transitoires de refroidissement sont très long du fait que la zone centrale présente des pertes thermiques très faibles, et il existe des transferts de chaleur par rayonnement entre les trois zones isothermes, de sorte que les influences mutuelles entre zones différentes rendent les contrôles de l'évolution de la température plus difficiles.

### Objet et description succincte de l'invention

La présente invention vise à remédier aux inconvénients précités et à permettre la réalisation d'un creuset et d'un four multizone pour dépôt en phase vapeur à haute température qui soient compacts, robustes, faciles à réaliser et à utiliser et permettent le traitement automatique successif de plusieurs échantillons, notamment en microgravité, dans des stations spatiales.

L'invention vise encore de façon plus particulière à faciliter l'examen d'un échantillon en cours de traitement, et à mesurer la température, notamment de la zone centrale, par voie optique, et à permettre un contrôle amélioré de cette température en mettant de plus en oeuvre un excellent découplage thermique des trois zones.

Ces différents buts sont atteints, grâce à un creuset pour dépôt en phase vapeur à haute température comprenant une enceinte fermée avec de façon successive un premier compartiment pour contenir un matériau source dans une première zone isotherme source à haute température, un deuxième compartiment pour contenir au moins un substrat dans une deuxième zone isotherme de dépôt, et un troisième compartiment pour constituer une troisième zone isotherme formant puits de chaleur, des grilles de séparation étant disposées d'une part entre les premier et deuxième compartiments et d'autre part entre les deuxième et troisième compartiments, **caractérisé** en ce que les premier, deuxième et troisième compartiments sont disposés de façon non alignée selon une ligne brisée, de telle sorte que les décalages angulaires assurent un découplage thermique radiatif entre lesdits premier, deuxième et troisième compartiments.

Grâce à la disposition particulière des compartiments du creuset, qui forment une ligne brisée, celui-ci peut être à la fois compact et plus rigide qu'un creuset rectiligne tubulaire tout en permettant une utilisation dans un four assurant un meilleur découplage thermique radiatif entre les différentes zones isothermes.

De préférence, le creuset est constitué en un matériau transparent aux rayons infra-rouge, tel que le quartz, et le creuset comprend dans les parties de raccordement d'une part entre les premier et deuxième compartiments et d'autre part entre les deuxième et troisième compartiments, des fenêtres planes d'observation.

Les fenêtres planes d'observation sont avantageusement inclinées par rapport à l'axe du deuxième compartiment de telle sorte qu'un faisceau de lumière polarisée d'observation orienté selon l'axe du deuxième compartiment arrive sur lesdites fenêtres d'observation sous l'incidence brewstérienne.

L'observation à l'aide d'un faisceau lumineux permet notamment de déterminer la pression du gaz, par interférométrie, la température, par pyrométrie infrarouge ou fluorescence, ainsi que l'épaisseur du dépôt ou la forme du cristal en cours de croissance.

Selon un premier mode de réalisation possible, les premier, deuxième et troisième compartiments sont disposés selon une structure en forme de U.

Dans ce cas, les premier et troisième compartiments peuvent être perpendiculaires au deuxième compartiment, ou selon une variante de réalisation chacun des premier et troisième compartiments forme avec le deuxième compartiment un angle obtus pour constituer une structure en U avec deux branches divergentes.

Selon un autre mode de réalisation les premier, deuxième et troisième compartiments sont disposés selon une structure en forme de Z. Une structure en forme de U est particulièrement adaptée à une utilisation dans l'espace, en microgravité, tout en étant également utilisable au sol.

Une structure en forme de Z permet lors d'une utilisation au sol, sous l'influence de la gravité, un effet de stratification permettant d'atténuer ou supprimer la convection naturelle.

Le creuset peut présenter une section de forme rectangulaire, trapézoïdale ou le cas échéant circulaire lorsque les tensions de vapeur sont élevées.

L'invention a encore pour objet un appareil pour dépôt en phase vapeur à haute température comprenant une enceinte isolante thermiquement des premier, deuxième et troisième diffuseurs pour constituer des première, deuxième et troisième zones de chauffage isotherme respectivement autour des premier, deuxième et troisième compartiments d'un creuset fermé amovible destiné à contenir un matériau source dans ledit premier compartiment, et un substrat dans le deuxième compartiment caractérisé en ce que les premier, deuxième et troisième diffuseurs sont par construction indépendants thermiquement les uns des autres et présentent chacun une section en forme de U pour enserrer respectivement les premier, deuxième et troisième compartiments du creuset et en ce que ces premier, deuxième et troisième compartiments sont disposés de façon non alignée, selon une ligne brisée, de telle sorte que les décalages angulaires assurent un découplage thermique radiatif entre lesdits premier, deuxième et troisième compartiments.

L'indépendance thermique des différents diffuseurs provient notamment du fait que les résistances chauffantes d'un même diffuseur sont directement connectées à une source de courant électrique, indépendamment des résistances des autres diffuseurs, et du fait que les résistances chauffantes sont intégrées dans des plaques à forte inertie thermique qui, d'un diffuseur à l'autre, sont séparées par des espaces isolants.

Chacun des premier, deuxième et troisième diffuseurs est fixé sur un socle commun par des colonnettes isolantes afin d'améliorer le découplage thermique de ces diffuseurs.

Avantageusement, au moins le deuxième diffuseur comprend des caloducs pour assurer l'isothermicité de la zone correspondant audit diffuseur selon l'axe du deuxième compartiment du creuset.

La structure en ligne brisée du creuset, qui permet le découplage thermique radiatif, l'indépendance thermique des différents diffuseurs et la présence de colonnettes isolantes concourrent à assurer un découplage thermique efficace des trois zones isothermes, qui constitue un effet important de la présente invention.

De façon plus particulière, le creuset est constitué en un matériau transparent aux rayons infra-rouge, tel que le quartz, et comprend, dans les parties de raccordement d'une part entre les premier et deuxième compartiments et d'autre part entre les deuxième et troisième compartiments, des fenêtres planes d'observation, et l'enceinte isolante de l'appareil comprend des bouchons amovibles, isolants thermiquement, situés en regard desdites fenêtres planes d'observation pour permettre l'envoi sélectif de rayons lumineux selon l'axe du deuxième compartiment du creuset afin de réaliser une visualisation par voie optique du dépôt à l'intérieur dudit deuxième compartiment.

Selon un autre aspect de la présente invention, l'enceinte isolante comprend une trappe, orientée essentiellement selon la plus grande dimension du deuxième compartiment du creuset et mobile dans une direction essentiellement transversale par rapport à l'axe de ce deuxième compartiment pour assurer un chargement et un déchargement du creuset.

L'appareil selon l'invention se prête à diverses variantes de réalisation qui sont cependant toutes d'une mise en oeuvre commode et favorisent un bon découplage thermique entre les diverses zones isothermes tout en conservant les avantages de compacité, robustesse, chargement et déchargement aisés d'un creuset ainsi que l'accessibilité à la zone centrale de dépôt pour une observation directe ou à l'aide d'une caméra de télévision du processus de dépôt et le cas échéant une régulation thermique.

L'appareil peut ainsi présenter une structure générale en U, les premier, deuxième et troisième compartiments du creuset étant disposés selon une structure en forme de U de même que les premier, deuxième et troisième diffuseurs destinés à créer des zones isothermes distinctes dans ces premier, deuxième et troisième compartiments.

Dans ce cas, selon un mode particulier de réalisation possible, le creuset présente une section de forme rectangulaire, les premier, deuxième et troisième diffuseurs à section en forme de U comprennent au moins une paroi interne inclinée et des cales conductrices de la chaleur, à profil triangulaire, sont interposées entre le creuset et les parois internes inclinées des diffuseurs.

Selon un autre mode particulier de réalisation, le creuset présente une section de forme trapézoïdale, chacun des premier et troisième compartiments forme avec le deuxième compartiment un angle obtus pour constituer une structure en U avec deux branches divergentes, et les premier, deuxième et troisième diffuseurs épousent les formes du creuset de manière à assurer à la fois un contact thermique direct par conduction entre les premier, deuxième, troisième diffuseurs et respectivement les premier,deuxième, troisième compartiments, et un centrage automatique du creuset.

Toutefois, pour faciliter la fabrication il est possible de réduire à quatre le nombre de faces du creuset et des diffuseurs se trouvant au contact les unes des autres, à savoir les deux faces inclinées du compartiment central et une face quelconque de chacun des compartiments extrêmes.

L'appareil peut également présenter un ensemble de chauffage à structure générale en forme de Z. Dans ce cas, les premier, deuxième et troisième compartiments du creuset, ainsi que les premier, deuxième et troisième diffuseurs sont disposés selon une structure en forme de Z.

Selon une caractéristique avantageuse, permettant le traitement automatique successif dans le même four de plusieurs échantillons contenus dans des creusets différents, l'appareil comprend un mécanisme de chargement et de déchargement automatiques de creuset, avec un couloir vertical de stockage de creusets, un chariot de positionnement des creusets dans le couloir vertical de stockage, et des moyens de déplacement de la trappe pour transférer automatiquement un creuset et entre le couloir vertical de stockage et l'enceinte isolante thermiquement et réciproquement.

### Brève description des dessins

D'autres caractéristiques et avantages de l'invention ressortiront de la description suivante de modes particuliers de réalisation, donnés à titre d'exemples, en référence aux dessins annexés, sur lesquels :
- la fig.1 est une vue schématique en coupe horizontale d'un appareil de dépôt en phase vapeur selon un premier mode de réalisation de l'invention avec un creuset et un four à structure en U,
- la fig.2 est une vue en perspective éclatée du creuset et de l'ensemble de chauffage de l'appareil de la fig.1,
- la fig.3 est une vue partielle en coupe selon le plan III-III de la fig.1, montrant des détails de la structure et du contenu du creuset en U,
- la fig.4 est une vue en coupe verticale de l'appareil de la fig.1 selon le plan IV-IV de la fig.1,
- la fig.5 est une vue en coupe axiale d'un creuset en forme de Z selon l'invention.
- la fig.6 est une vue schématique en coupe horizontale d'un appareil de dépôt en phase vapeur selon un deuxième mode de réalisation de l'invention avec un creuset et un four à structure en Z,
- la fig.7 est une vue partielle en coupe verticale selon le plan VII-VII de la fig.8 montrant une variante de réalisation d'un creuset et d'un four à structure en U à section trapézoïdale,
- la fig.8 est une vue partielle en coupe horizontale selon le plan VIII-VIII de la fig.7 montrant une forme de creuset à structure en U à bras divergents non perpendiculaires à la partie centrale,
- les fig.9 et 10 sont des vues partielles en coupe verticale montrant des agencements particuliers d'un creuset en U de section rectangulaire dans des diffuseurs thermiques à section en U à paroi inclinées, avec interposition de cales conductrices,
- les fig.11 et 12 sont des vues partielles en coupe horizontale montrant des agencements particuliers d'un creuset en U dans des diffuseurs thermiques à section en U à parois inclinées, avec le cas échéant interposition de cales conductrices de la chaleur,
- la figure 13 est une vue en coupe selon le plan XIII-XIII de la figure 4, montrant un mécanisme de chargement et de déchargement de creuset, et
- la fig. 14 est une vue en coupe longitudinale d'un four multizone rectiligne de l'art antérieur destiné à la réalisation de dépôts en phase vapeur.

### Description détaillée de modes particuliers de réalisation

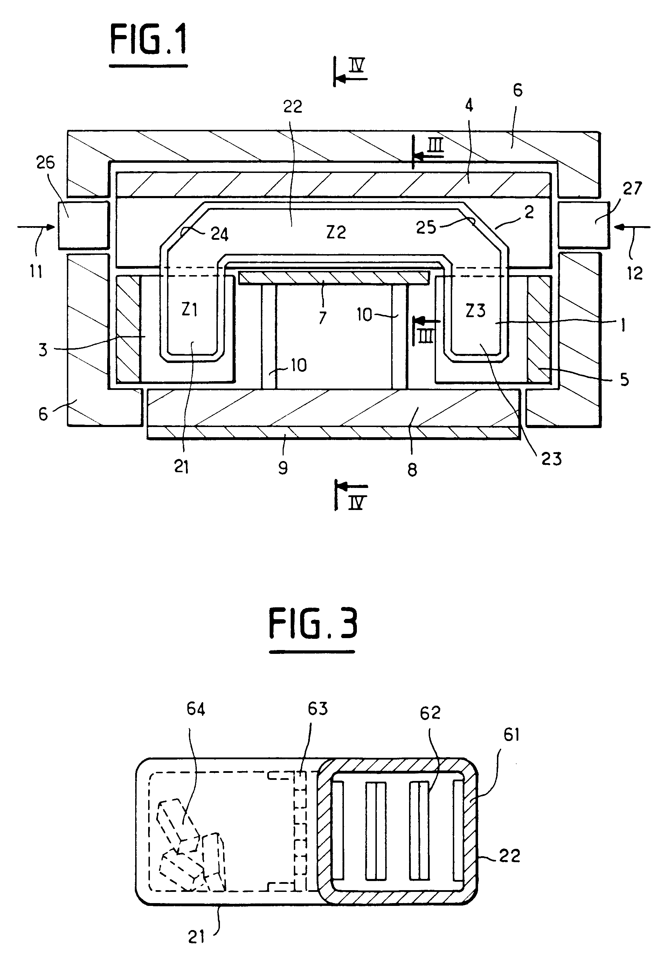

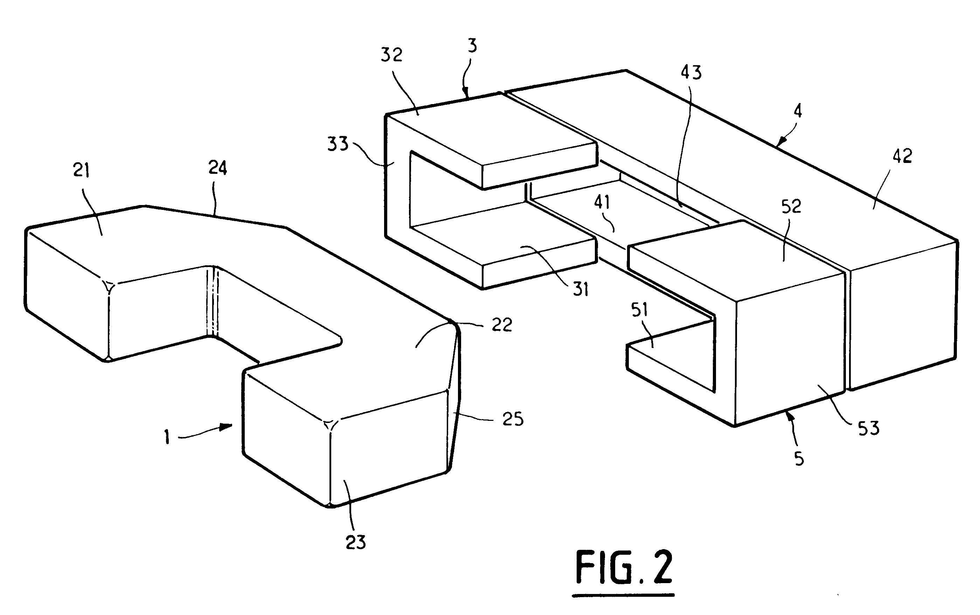

On décrira tout d'abord en référence aux figures 1 à 4 un premier mode de réalisation d'un appareillage selon l'invention destiné à permettre d'effectuer des dépôts en phase vapeur, tels qu'une diffusion en phase vapeur ou une croissance cristalline.

D'une manière générale, contrairement aux fours multizones rectilignes connus, l'appareillage selon l'invention se caractérise par la mise en oeuvre d'un creuset comprenant différents tronçons coplanaires successifs délimités entre eux par des grilles perméables à la vapeur, les tronçons définissant longitudinalement une ligne brisée et correspondant à des zones de températures différentes, et les deux extrémités libres de la ligne brisée étant obturées par des parois terminales.

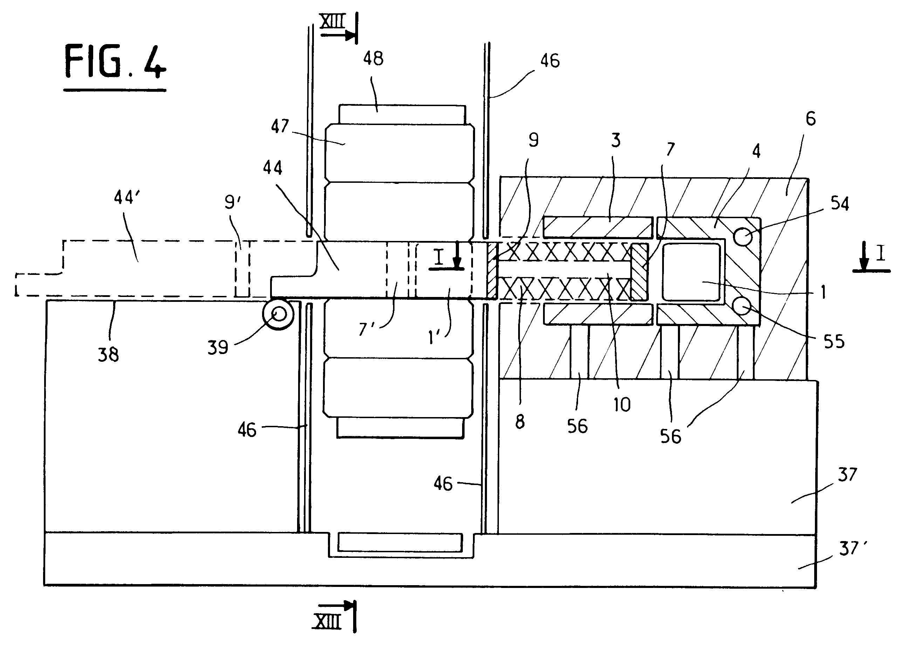

Dans le mode de réalisation des figures 1 à 4, le creuset 1 présente une structure générale en forme de U, avec une partie centrale rectiligne 22 définissant un compartiment destiné à recevoir un ou plusieurs substrats 62 (figure 3), et deux branches d'extrémité 21, 23 sensiblement perpendiculaires à la partie centrale rectiligne 22. La première branche d'extrémité 21 du creuset 1 définit un premier compartiment source destiné à contenir des cristaux 64 du matériau émetteur de vapeur, tandis que la deuxième branche d'extrémité 23 du creuset 1 définit un troisième compartiment formant puits de chaleur et dans lequel peuvent être également placés quelques cristaux le cas échéant.

Des grilles, telle que la grille 63 de la figure 3, assurent une séparation entre chacun des compartiments des branches d'extrémité 21, 23 et le compartiment du corps rectiligne central 22 du creuset 1.

Le creuset 1, qui est par exemple réalisé en quartz ou en silice, peut présenter des dimensions réduites et par exemple ne pas dépasser environ 150 mm dans sa plus grande dimension tandis que les creusets rectilignes classiques présentent eux-mêmes une longueur qui est généralement le double.

Le creuset 1 est destiné à être placé dans un four pouvant comporter une enceinte 6 isolante thermiquement de forme essentiellement parallélépipédique. Une porte 9 comportant également une isolation thermique 8, ainsi qu'une plaque chauffante interne 7 positionnée par rapport à le porte proprement dite 9 à l'aide de colonnettes isolantes 10 est intégrée dans l'enceinte 6 sur une face avant principale donnant accès au creuset 1 et permettant un chargement et un déchargement dans un sens transversal par rapport au compartiment central 22 (figures 1 et 4).

Le creuset 1 en forme de U est placé dans le four entre des diffuseurs thermiques 3, 4, 5 (figures 1, 2 et 4) qui présentent eux-mêmes chacun une structure en U et sont disposés les uns par rapport aux autres selon un U pour enserrer chaque compartiment 21, 22, 23 du creuset 1 sur trois côtés, tout en permettant un dégagement du creuset 1 par simple coulissement lors de l'ouverture de la porte 9.

Le compartiment 21 de la première branche d'extrémité du creuset 1, destiné à contenir le matériau source de vapeur, est chauffé par le diffuseur en U 3 qui l'entoure par sa face arrière centrale 33 et ses branches latérales inférieure et supérieure 31, 32.

De manière similaire et symétrique par rapport au plan de symétrie vertical du creuset 1, le compartiment 23 de la deuxième branche d'extrémité du creuset 1, constituant un puits de chaleur, est chauffé par le diffuseur en U 5 qui entoure ce compartiment 23 par sa face arrière centrale 53, et ses branches latérales inférieure et supérieure 51, 52.

Le diffuseur en U 4, destiné à chauffer le compartiment central 22 du creuset 1 contenant les substrats receveurs de vapeur, épouse la forme de ce compartiment central et présente une face verticale arrière 43 et des branches latérales inférieure et supérieure 41, 42.

Dans la présente description, les termes "vertical" ou "horizontal" ne sont naturellement pas limitatifs, dans la mesure où l'appareil est lui-même particulièrement adapté pour une utilisation dans une station spatiale. Ces termes ne sont utilisés que pour faciliter la compréhension, le plan de la figure 1 étant par convention défini comme étant horizontal.

La disposition des diffuseurs 3, 4, 5 empêche tout transfert radiatif entre les trois zones isothermes de source Z1, de dépôt Z2 et de puits Z3 dans lesquelles sont placés les compartiments 21, 22 et 23 du creuset 1, permettant ainsi un meilleur contrôle des conditions thermiques.

Le chauffage de chaque diffuseur est assuré par exemple par des résistances électriques.

Les résistances électriques chauffantes d'un même diffuseur sont directement connectées à une source de courant électrique indépendamment des résistances, des autres diffuseurs. Par ailleurs, les plaques à forte inertie thermique dans lesquelles ces résistances sont intégrées et qui constituent les corps des diffuseurs sont séparées d'un diffuseur à l'autre par des espaces isolants. Ceci contribue à renforcer le découplage thermique des trois zones isothermes.

L'isothermicité de chaque zone peut être assurée par des caloducs 54, 55, par exemple à potassium, sodium ou lithium, suivant la température visée (pouvant aller par exemple de 500° C à 1 200° C).

L'isolant thermique présent dans l'enceinte du four 6 ou dans la porte 9 (espace 8) peut être constitué par un superisolant sous vide.

La plaque chauffante 7 intégrée dans la porte 9 et positionnée par des colonnettes isolantes 10 entourées de matière isolante 8 par rapport à la porte 9, contribue à assurer une fermeture du dispositif de chauffage constitué par le diffuseur 4, sur la face du creuset 1 située en regard de la porte 9.

Des bouchons isolants 26, 27 peuvent être placés de façon amovible dans l'enceinte isolante 6, par exemple dans l'alignement du compartiment principal 22 comme représenté sur la figure 1, ou encore le cas échéant dans l'alignement des branches latérales 21, 22.

Les bouchons isolants 26, 27, lorsqu'ils sont ôtés, permettent le passage d'un faisceau lumineux 11, 12 à travers le creuset transparent 1, pour visualiser la zone de dépôt Z2, soit directement, soit par l'intermédiaire d'une caméra, contrôler le processus de dépôt et le cas échéant le réguler.

Avantageusement, le faisceau lumineux 11, 12 pénètre dans le creuset 1 par des fenêtres 24, 25 constituées par des surfaces planes inclinées par rapport à l'axe du faisceau 11, 12 de telle manière que ce faisceau arrive sous une incidence brewstérienne. Ceci contribue à diminuer les pertes par réflexion en lumière polarisée.

Sur la figure 1, les fenêtres 24, 25 constituent des pans coupés au niveau des arêtes externes dans les zones de liaison entre les branches latérales 21, 23 et le compartiment central 22.

L'observation à l'aide d'un faisceau lumineux permet notamment de déterminer
. la pression du gaz (par interférométrie)
. la température (par pyrométrie infrarouge ou fluorescence)
. l'épaisseur du dépôt ou la forme du cristal en cours de croissance.

Après examen optique, les bouchons 26,27 peuvent être fermés pour éviter des distorsions du champ thermique.

La structure en U du creuset est ainsi particulièrement intéressante dans la mesure où elle permet d'examiner la croissance dans le compartiment central 22 sans obstruction visuelle de la part des deux autres compartiments 21, 23.

La forme ramassée du four permet par ailleurs de diminuer les pertes thermiques et d'augmenter la robustesse du four, en particulier sa tenue aux vibrations, ainsi que celle du creuset. De plus, grâce en particulier au choix d'une section de creuset rectangulaire, ou trapézoïdale, il est possible de disposer à l'intérieur du creuset 1 un nombre d'échantillons plus important que dans un creuset cylindrique. La disposition en ligne brisée, et notamment en U du four permet d'assurer une réelle indépendance thermique des trois zones Z1, Z2, Z3 et en particulier d'assurer les montées et descentes en température de chaque zone indépendamment des deux autres.

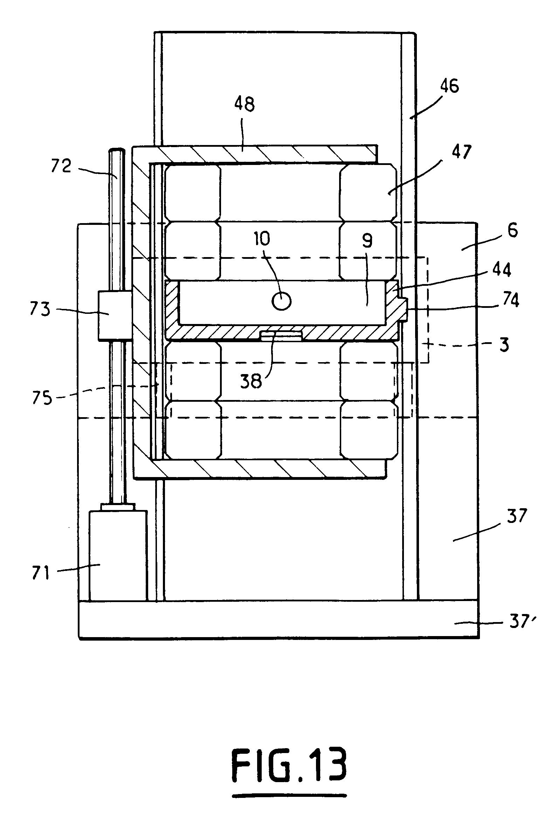

Les figures 4 et 13 montrent de quelle manière un système de chargement automatique peut être associé au four.

Les échantillons 47 sont placés dans un couloir ou puits vertical 46 et sont positionnés par un chariot ou mécanisme d'indexage 48 se déplaçant dans le couloir 46 sous l'action d'un mécanisme d'entraînement du type comprenant un écrou 73 solidaire du mécanisme d'indexage 48, et une vis 72 en prise avec l'écrou 73 et entraînée en rotation par un moteur électrique d'entraînement 71 (fig. 13). La porte dechargement 9, avec son matériau isolant thermiquement 8 et sa plaque chauffante 7 peut être déplacée, par exemple par un système pignon 39-crémaillère 38, commandé à partir d'un mécanisme de translation et d'enfournement.

On voit sur la figure 4 un tiroir 44 de commande de la porte de chargement 9. Le tiroir 44 et la porte 9 sont représentés en traits pleins dans leur position de travail pour laquelle le creuset 1 est installé dans le four. Ces éléments sont également représentés dans leur position de chargement ou déchargement, en traits discontinus et sont repérés par des références primées. On voit ainsi en pointillés le tiroir 44', la porte 9', avec ses éléments 7', 8' et le creuset 1' sortis du four pour un échange de creusets. Le tiroir 44 se trouve guidé horizontalement par une nervure 74 engagée dans une rainure ménagée horizontalement dans une paroi du couloir 46 perpendiculaire à la porte de chargement 9 (fig. 13). Un dégagement 75 est ménagé dans la partie arrière du chariot 48 pour permettre la descente du chariot 48 jusqu'au voisinage du socle 37' sans heurter le moteur 71.

Le mode de stockage en empilage des creusets contenant différents échantillons à traiter successivement dans le four est très compact et assure une bonne tenue aux vibrations. Une plaque de matériau amortisseur peut en outre être disposée entre chaque creuset 47 pour améliorer la tenue aux vibrations.

Naturellement, le dispositif de chargement et déchargement de creusets peut prendre des formes très variées dès lors qu'il permet d'enfourner et de récupérer un creuset à traiter dans le four à l'aide d'une porte 9 de chargement latéral solidaire d'un tiroir 44 de réception d'un échantillon.

La figure 4 montre encore des colonnettes 56 servant à isoler les diffuseurs 3,4,5 par rapport à un socle 37 supportant l'enceinte isolante 6.

Le four de dépôt en phase vapeur est particulièrement adapté à des utilisations dans des stations spatiales, où le processus de dépôt est facilité par l'absence de mouvement de convection naturelle de la vapeur, alors que ce phénomène est inévitable au sol où il ralentit la vitesse de croissance des cristaux.

Toutefois, l'appareillage selon l'invention conserve tous ses avantages lorsqu'il est utilisé au sol et peut même dans ce cas présenter plus facilement d'autres types de configurations, par exemple avec des zones thermiques disposées en Z ou en marches d'escalier.

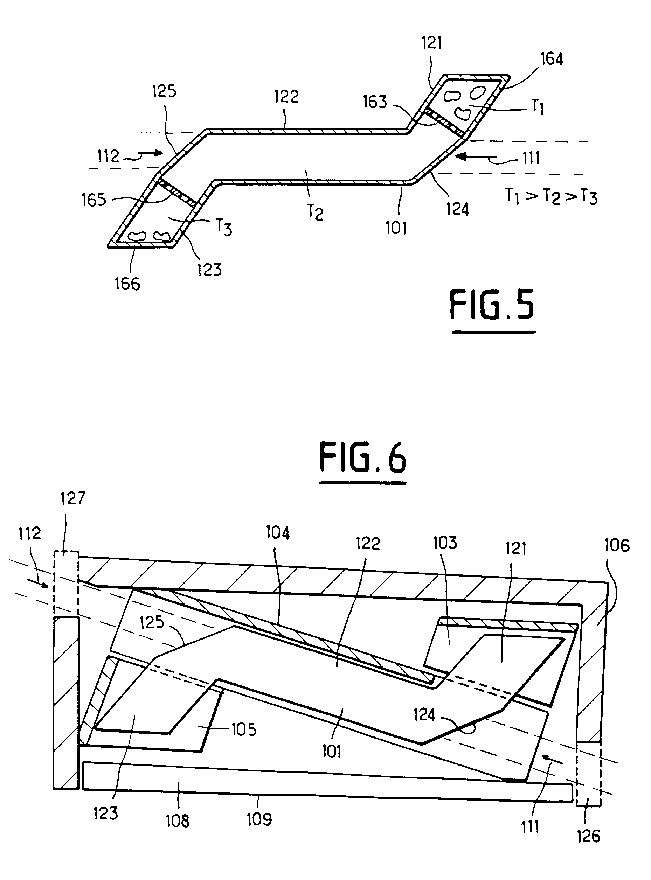

La figure 5 montre ainsi un creuset 101 en forme de Z, qui permet notamment d'exploiter au sol, c'est-à-dire sous l'influence de l'attraction terrestre (1g), un effet de stratification permettant d'atténuer ou supprimer la convection naturelle.

Le creuset 101 en forme de Z présente de même que le creuset 1 en forme de U, une compartiment central rectiligne de dépôt 122 prolongé à ses extrémités par des branches latérales d'extrémités 121, 123 qui définissent respectivement un compartiment source contenant les cristaux 164 à vaporiser et un compartiment formant puits de chaleur et pouvant également contenir quelques cristaux 165. Les branches d'extrémité 121, 123 sont toutefois orientées dans des sens opposés par rapport au compartiment central, pour former un Z. Des grilles 163, 165 assurent, comme dans le mode de réalisation précédent, une séparation entre les compartiments qui reste perméable à la vapeur. Des fenêtres 124, 125, inclinées par rapport à l'axe du compartiment central 122 permettent le passage d'un faisceau lumineux d'observation 111, 112 qui de préférence arrive sous une incidence brewsterienne. Les fenêtres 124,125 peuvent être dans l'alignement des parois extérieures des compartiments d'extrémité 121, 123 ou au contraire former un certain angle par rapport à celles-ci comme représenté sur la figure 5.

La figure 6 montre la façon dont le creuset 101 de la figure 5 peut être intégré dans un four comportant lui-même des diffuseurs 103, 104, 105 à section en U mais disposés selon une structure en Z.

Le four de la figure 6 comporte, comme dans le mode de réalisation précédent, une enceinte isolante 106 et une porte de chargement 109, également munie d'un garnissage isolant 108, qui peuvent présenter une structure tout à fait semblable à celle des éléments correspondants du mode de réalisation des figures 1 et 4. Des bouchons d'obturation isolants amovibles 126, 127 permettent également de faire passer sélectivement un faisceau lumineux d'observation 111, 112 à travers le creuset 101.

Pour limiter l'encombrement, le creuset 101 peut être disposé dans l'enceinte 106 avec l'axe du compartiment central de dépôt 122 incliné par rapport aux faces principales de l'enceinte 106. Les diffuseurs 103, 104, 105 créant les zones de température isothermes dans les compartiments 121, 122, 123 présentent une section en U et sont placés selon une configuration en Z pour épouser la forme du creuset 101 tout en permettant un dégagement du creuset 101 par la porte de chargement 109. Le diffuseur situé en arrière du diffuseur central 104, par rapport à la porte 109 (diffuseur 103 sur la figure 6) peut présenter une face verticale qui est montée selon les faces principales de l'enceinte 106, comme représenté sur le dessin, mais qui pourrait également être orientée dans un sens transversal, comme la face verticale du diffuseur 105.

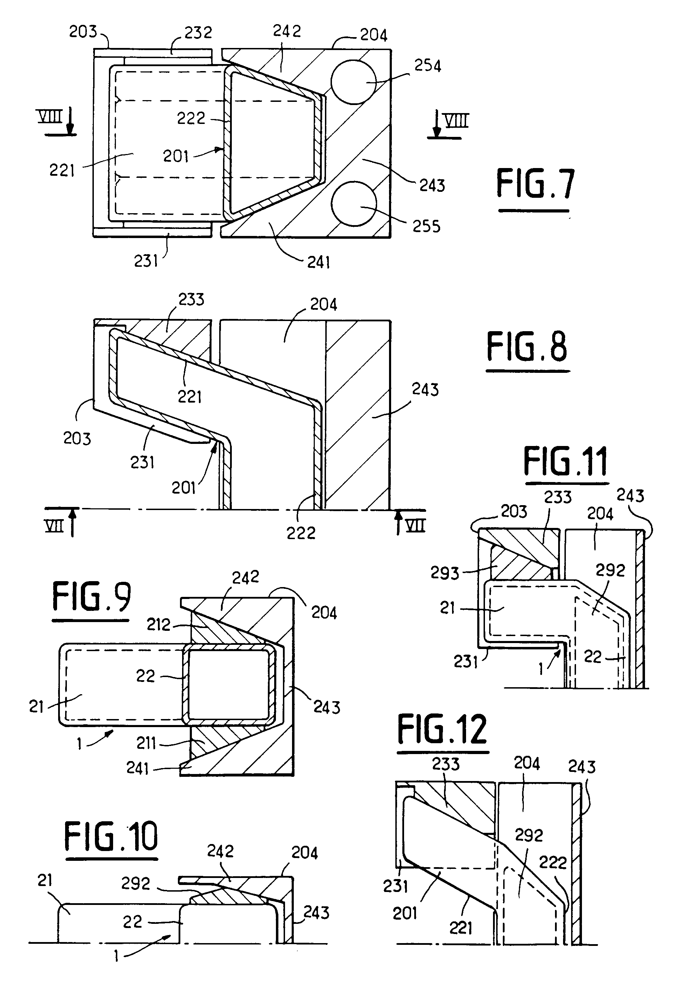

Les figures 7 à 12 montrent diverses variantes de réalisation applicables au creuset 1 et aux diffuseurs 3 à 5 des figures 1 à 4, de même qu'au creuset 101 et aux diffuseurs 103 à 105 de la figure 6.

Les figures 7 et 8 montrent une partie de creuset 201 coopérant avec des diffuseurs 204, 203 en forme de U, mais présentant des branches latérale 241, 242, ou une branche centrale 233, inclinées pour épouser la forme du creuset 201 qui présente une section trapézoïdale et non rectangulaire, et des branches d'extrémité, telle que 221, orientées vers l'extérieur, c'est à dire divergeant vers l'extérieur. Dans ce mode de réalisation, les faces internes des branches 241, 242, du diffuseur 204 sont en contact avec la paroi du compartiment central 202 du creuset 201 et la face interne de la branche centrale 233 du diffuseur 203 est en contact avec la paroi du compartiment 221. De façon similaire, le troisième diffuseur, non représenté, est en contact, comme le premier diffuseur 203, avec le troisième compartiment du creuset 201.

Dans cette variante de réalisation, le contact thermique entre chacune des trois zones isothermes et chacun des diffuseurs est ainsi assuré par conduction.

Les deux profils en V ouvert constitués par l'ensemble des trois diffuseurs constituent en outre un moyen de centrer automatiquement le creuset 201.

Les figures 9 à 12 concernent des variantes de réalisation dans lesquelles le creuset 1 présente une section rectangulaire, comme dans le cas des figures 1 à 4, mais les diffuseurs tels que 203, 204 présentent des faces internes inclinées, comme dans la variante des figures 7 et 8. Dans ce cas, le contact entre le creuset à section rectangulaire 1 et l'ouverture en V ouvert d'un diffuseur est assuré au moyen de cales conductrices de la chaleur 291, 292, 293.

La figure 10 montre un profil particulier de cales 292 qui permet de diminuer l'encombrement du diffuseur.

La figure 12 montre une variante de réalisation dans laquelle le creuset 201 présente une section rectangulaire, mais les branches latérales d'extrémité, telle que celle définissant le compartiment 221, forment un V ouvert et divergent vers l'extérieur, comme dans le cas des figures 7 et 8, et ne sont pas perpendiculaires au compartiment central. On voit ainsi sur la figure 12 une cela conductrice 292 interposée entre le compartiment central 222 et le diffuseur central 204 tandis que le compartiment 221 est en contact direct avec la paroi verticale inclinée de la partie 233 du diffuseur 203.

Sur la figure 7, les références 254 et 255 désignent des emplacements pour des caloducs destinés à homogénéiser la température entre les deux extrémités de la partie centrale 243 du diffuseur central 204.

L'appareil selon l'invention est applicable à divers types de dépôts en phase vapeur notamment dans l'espace, mais trouve également une utilisation dans des applications au sol comme par exemple des fours d'épitaxie de monocristaux dopés pour l'infrarouge (Hg Cd Te, In Sb, par exemple).

## Revendications

1. Creuset pour dépôt en phase vapeur à haute température comprenant une enceinte fermée avec de façon successive un premier compartiment (21; 121; 221) pour contenir un matériau source (64; 164) dans une première zone isotherme source à haute température, un deuxième compartiment (22 ; 122; 222) pour contenir au moins un substrat (62) dans une deuxième zone isotherme de dépôt, et un troisième compartiment (23; 123; 223) pour constituer une troisième zone isotherme formant puits de chaleur, des grilles de séparation (63, 163, 165) étant disposées d'une part entre les premier et deuxième compartiments (21, 22; 121, 122; 221, 222) et d'autre part entre les deuxième et troisième compartiments (22, 23; 122, 123; 222, 223),
caractérisé en ce que les premier, deuxième et troisième compartiments (21, 22, 23; 121, 122, 123; 221, 222, 223) sont disposés de façon non alignée selon une ligne brisée, de telle sorte que les décalages angulaires assurent un découplage thermique radiatif entre lesdits premier, deuxième et troisième compartiments (21 à 23; 121 à 123; 221 à 223).

2. Creuset selon la revendication 1, caractérisé en ce qu'il est constitué en un matériau transparent aux rayons infra-rouge, tel que le quartz, et en ce qu'il comprend, dans les parties de raccordement d'une part entre les premier et deuxième compartiments (21, 22; 121, 122; 221, 222) et d'autre part entre les deuxième et troisième compartiments (22, 23; 122, 123; 222, 223), des fenêtres planes d'observation (24, 25; 124, 125).

3. Creuset selon la revendication 2, caractérisé en ce que les fenêtres planes d'observation (24, 25; 124, 125) sont inclinées par rapport à l'axe du deuxième compartiment (22; 122; 222) de telle sorte qu'un faisceau de lumière polarisée d'observation orienté selon l'axe du deuxième compartiment (22; 122; 222) arrive sur lesdites fenêtres d'observation (24, 25; 124, 125) sous l'incidence brewstérienne.

4. Creuset selon l'une quelconque des revendications 1 à 3, caractérisé en ce que les premier, deuxième et troisième compartiments (21, 22, 23; 221, 222, 223) sont disposés selon une structure en forme de U.

5. Creuset selon la revendication 4, caractérisé en ce que les premier et troisième compartiments (21, 23) sont perpendiculaires au deuxième compartiment (22).

6. Creuset selon la revendication 4, caractérisé en ce que chacun des premier et troisième compartiments (221, 223) forme avec le deuxième compartiment (222) un angle obtus pour constituer une structure en U avec deux branches divergentes.

7. Creuset selon l'une quelconque des revendications 1 à 3, caractérisé en ce que les premier, deuxième et troisième compartiments (121, 122, 123) sont disposés selon une structure en forme de Z.

8. Creuset selon l'une quelconque des revendications 1 à 7, caractérisé en ce qu'il présente une section de forme rectangulaire.

9. Creuset selon l'une quelconque des revendications 1 à 7, caractérisé en ce qu'il présente une section de forme trapézoïdale.

10. Creuset selon l'une quelconque des revendications 1 et 4 à 7, caractérisé en ce qu'il présente une section circulaire.

11. Appareil pour dépôt en phase vapeur à haute température comprenant une enceinte (6) isolante thermiquement, des premier, deuxième et troisième diffuseurs (3, 4, 5) pour constituer des première, deuxième et troisième zones de chauffage isotherme respectivement autour des premier, deuxième et troisième compartiments (21, 22, 23; 121 à 123; 221 à 223) d'un creuset fermé amovible (1) destiné à contenir un matériau source (64; 164) dans ledit premier compartiment (21; 121; 221), et un substrat (62) dans le deuxième compartiment (22; 122; 222),
caractérisé en ce que les premier, deuxième et troisième diffuseurs (3,4,5) sont par construction indépendants thermiquement les uns des autres et présentent chacun une section en forme de U pour enserrer respectivement les premier, deuxième et troisième compartiments (21, 22, 23; 121, 122, 123; 221, 222, 223) du creuset et en ce que ces premier, deuxième et troisième compartiments (21 à 23; 121 à 123; 221 à 223) sont disposés de façon non alignée, selon une ligne brisée, de telle sorte que les décalages angulaires assurent un découplage thermique radiatif entre lesdits premier, deuxième et troisième compartiments (21 à 23; 121 à 123; 221 à 223).

12. Appareil selon la revendication 11, caractérisé en ce que le creuset (1) est constitué en un matériau transparent aux rayons infrarouge, tel que le quartz, et comprend, dans les parties de raccordement d'une part entre les premier et deuxième compartiments (21, 22; 121, 122; 221, 222) et d'autre part entre les deuxième et troisième compartiments (22, 23; 122, 123; 222, 223), des fenêtres planes d'observation (24, 25; 124, 125), et en ce que l'enceinte isolante (6) de l'appareil comprend des bouchons amovibles (26, 27), isolants thermiquement, situés en regard desdites fenêtres planes d'observation (24, 25; 124, 125) pour permettre l'envoi sélectif de rayons lumineux selon l'axe du deuxième compartiment (22; 122; 222) du creuset (1) afin de réaliser une visualisation par voie optique du dépôt à l'intérieur dudit deuxième compartiment (22; 122; 222).

13. Appareil selon la revendication 12, caractérisé en ce que les fenêtres planes d'observation (24, 25; 124, 125) sont inclinées par rapport à l'axe du deuxième compartiment (22; 122; 222) de telle sorte qu'un faisceau de lumière polarisée d'observation orienté selon l'axe du deuxième compartiment (22; 122; 222) arrive sur lesdites fenêtres d'observation (24, 25; 124, 125) sous l'incidence brewstérienne.

14. Appareil selon l'une quelconque des revendications 11 à 13, caractérisé en ce que l'enceinte isolante (6) comprend une trappe (9) orientée essentiellement selon la plusgrande dimension du deuxième compartiment (22; 122; 222) du creuset (1) et mobile dans une direction essentiellement transversale par rapport à l'axe de ce deuxième compartiment pour assurer un chargement et un déchargement du creuset (1).

15. Appareil selon l'une quelconque des revendications 11 à 14, caractérisé en ce que chacun des premier, deuxième et troisième diffuseurs (3, 4, 5) est fixé sur un socle commun (37) par des colonnettes isolantes (56).

16. Appareil selon l'une quelconque des revendications 11 à 15, caractérisé en ce qu'au moins le deuxième diffuseur (4) comprend des caloducs (54, 55) pour assurer l'isothermicité de la zone correspondant audit diffuseur (4) selon l'axe du deuxième compartiment (22; 122; 222) du creuset (1).

17. Appareil selon l'une quelconque des revendications 11 à 16, caractérisé en ce que les premier, deuxième et troisième compartiments (21 à 23; 221 à 223) du creuset (1), ainsi que les premier, deuxième et troisième diffuseurs (3, 4, 5) sont disposés selon une structure en forme de U.

18. Appareil selon la revendication 17, caractérisé en ce que le creuset (1) présente une section de forme rectangulaire, en ce que les premier, deuxième et troisième diffuseurs (3, 4, 5) à section en forme de U comprennent au moins une paroi interne inclinée et en ce que des cales (291, 292) conductrices de la chaleur, à profil triangulaire, sont interposées entre le creuset (1) et les parois internes inclinées des diffuseurs (3, 4, 5).

19. Appareil selon la revendication 17, caractérisé en ce que le creuset (1) présente une section de forme trapézoïdale, en ce que chacun des premier et troisième compartiments (221, 223) forme avec le deuxième compartiment (222) un angle obtus pour constituer une structure en U avec deux branches divergentes, et en ce que les premier, deuxième et troisième diffuseurs (3, 4, 5) épousant les formes du creuset de manière à assurer à la fois un contact thermique direct par conduction entre les premier, deuxième, troisième diffuseurs (3, 4, 5) et respectivement les premier, deuxième, troisième compartiments (221, 222, 223), et un centrage automatique du creuset (1).

20. Appareil selon l'une quelconque des revendications 11 à 16, caractérisé en ce que les premier, deuxième et troisième compartiments (121 à 123) du creuset (1), ainsi que les premier, deuxième et troisième diffuseurs (103, 104, 105) sont disposés selon une structure en forme de Z.

21. Appareil selon la revendication 14, caractérisé en ce qu'il comprend un mécanisme de chargement et de déchargement automatiques de creuset, avec un couloir vertical (46) de stockage de creusets (47), un chariot (48) de positionnement des creusets dans le couloir vertical (46) de stockage, et des moyens (38, 39) de déplacement de la trappe (9) pour transférer automatiquement un creuset (1) entre le couloir vertical (46) de stockage et l'enceinte (6) isolante thermiquement et réciproquement.

## Claims

1. Crucible for vapor deposition at high temperature comprising an enclosure including the following in succession: a first compartment (21; 121; 221) for containing a source material (64; 164) in a source first isothermal zone at high temperature, a second compartment (22; 122; 222) for containing at least one substrate (62) in a deposition second isothermal zone, and a third compartment (23; 123; 223) for constituting a third isothermal zone that forms a heat sink, separation grids (63, 163, 165) being disposed firstly between the first and second compartments (21, 22; 121, 122; 221, 222) and secondly between the second and third compartments (22, 23; 122, 123; 222, 223),
characterized in that the first, second, and third compartments (21,22, 23; 121, 122, 123; 221, 222, 223) are disposed in non-aligned manner along an angled line such that the angles between said first, second, and third compartments (21 to 23; 121 to 123; 221 to 223) provide thermal decoupling of radiant energy between said compartments.

2. Crucible according to claim 1, characterized in that it is made of a material that is transparent to infrared radiation, such as quartz, and in that it includes planar observation windows (24, 25; 124, 125) in its connection portions firstly between the first and second compartments (21, 22; 121, 122; 221, 222) and secondly between the second and third compartments (22, 23; 122, 123; 222, 223).

3. Crucible according to claim 2, characterized in that the planar observation windows (24, 25; 124, 125) are inclined relative to the axis of the second compartment (22; 122; 222) in such a manner that a polarized observation light beam propagating along the axis of the second compartment (22; 122; 222) strikes said observation windows (24, 25; 124, 125) at the Brewster angle.

4. Crucible according to any one of claims 1 to 3, characterized in that the first, second, and third compartments (21, 22, 23; 221, 222, 223) are disposed in a U-shaped structure.

5. Crucible according to claim 4, characterized in that the first and third compartments (21, 23) are perpendicular to the second compartment (22).

6. Crucible according to claim 4, characterized in that each of the first and third compartments (221, 223) is at an obtuse angle to the second compartment (222), thereby constituting a U-shaped structure with two diverging branches.

7. Crucible according to any one of claims 1 to 3, characterized in that the first, second, and third compartments (121, 122, 123) are disposed in a Z-shaped structure.

8. Crucible according to any one of claims 1 to 7, characterized in that its section is rectangular in shape.

9. Crucible according to any one of claims 1 to 7, characterized in that its section is trapezoidal.

10. Crucible according to any one of claims 1 and 4 to 7, characterized in that its section is circular.

11. Apparatus for vapor deposition at high temperature, the apparatus comprising a thermally insulating enclosure (6), first, second, and third diffusers (3, 4, 5) for constituting first, second, and third isothermal heating zones respectively around first, second, and third compartments (21, 22, 23; 121 to 123; 221 to 223) of a removable closed crucible (1) designed to contain a source material (64; 164) in said first compartment (21; 121; 221) and a substrate (62) in the second compartment (22; 122; 222),
characterized in that the first, second, and third diffusers (3, 4, 5) are thermally independent from one another by construction, each of them having a U-shaped section to surround the first, second, and third compartments (21, 22, 23; 121, 122, 123; 221, 222, 223) of the crucible respectively, and in that said first, second, and third compartments (21 to 23; 121 to 123; 221 to 223) are disposed in non-aligned manner along an angled line such that the angles between said first, second, and third compartments (21 to 23; 121 to 123; 221 to 223) provide thermal decoupling of radiant energy between said compartments.

12. Apparatus according to claim 11, characterized in that the crucible (1) is made of a material that is transparent to infrared radiation, such as quartz, and includes planar observation windows (24, 25; 124, 125) in its connection portions firstly between the first and second compartments (21, 22; 121, 122; 221, 222) and secondly between the second and third compartments (22, 23; 122, 123; 222, 223), and in that the insulating enclosure (6) of the apparatus includes thermally insulating removable plugs (26, 27) located opposite said planar observation windows (24, 25; 124, 125) to enable light rays to be sent selectively along the axis of the second compartment (22; 122; 222) of the crucible (1) in order to observe the deposit inside said second compartment (22; 122; 222) optically.

13. Apparatus according to claim 12, characterized in that the planar observation windows (24, 25; 124, 125) are inclined relative to the axis of the second compartment (22; 122; 222) in such a manner that a polarized light beam for observation purposes propagating along the axis of the second compartment (22; 122; 222) strikes said observation windows (24, 25; 124, 125) at the Brewster angle.

14. Apparatus according to any one of claims 11 to 13, characterized in that the insulating enclosure (6) includes a door (9) extending essentially along the longest dimension of the second compartment (22; 122; 222) of the crucible (1) and movable in a direction that is essentially transverse relative to the axis of the second compartment, thereby enabling the crucible (1) to be loaded and unloaded.

15. Apparatus according to any one of claims 11 to 14, characterized in that each of the first, second, and third diffusers (3, 4, 5) is fixed on a common base (37) via insulating columns (56).

16. Apparatus according to any one of claims 11 to 15, characterized in that at least the second diffuser (4) includes heat pipes (54, 55) for ensuring the isothermal nature of the zone corresponding to said diffuser (4) along the axis of the second compartment (22; 122; 222) of the crucible (1).

17. Apparatus according to any one of claims 11 to 16, characterized in that the first, second, and third compartments (21 to 23; 221 to 223) of the crucible (1), and the first, second, and third diffusers (3, 4, 5) are disposed in a U-shaped structure.

18. Apparatus according to claim 17, characterized in that the crucible (1) is rectangular in section, in that the first, second, and third U-shaped section diffusers (3, 4, 5) include at least one inside wall that is sloping, and in that triangular-section heat conducting wedges (291, 292) are interposed between the crucible (1) and the sloping inside walls of the diffusers (3,4,5).

19. Apparatus according to claim 17, characterized in that the crucible (1) has a tapezoidal section, in that each of the first and third compartments (221, 223) is at an obtuse angle relative to the second compartment (222), thereby constituting a U-shaped structure with two diverging branches, and in that the first, second, and third diffusers (3, 4, 5) match the shapes of the crucible in such a manner as to provide both direct thermal contact by conduction between the first, second, and third diffusers (3, 4, 5) and the first, second, and third compartments (221, 222, 223) respectively, and also automatic centering of the crucible (1).

20. Apparatus according to any one of claims 11 to 16, characterized in that the first, second, and third compartments (121 to 123) of the crucible (1), and the first, second, and third diffusers (103, 104, 105) are disposed in a Z-shaped structure.

21. Apparatus according to claim 14, characterized in that it includes an automatic crucible loading and unloading mechanism having a vertical storage passage (46) for storing crucibles (47), a carriage (48) for positioning the crucibles in the vertical storage passage (46), and door (9) displacement means (38, 39) for automatically transferring a crucible (1) between the vertical storage passage (46) and the thermally insulating enclosure (6) and *vice versa*.

## Patentansprüche

1. Tiegel zum Abscheiden aus der Gasphase bei hoher Temperatur mit einem geschlossenen Behälter mit nacheinander einem ersten Fach (21; 121; 221), das ein Quellenmaterial (64; 164) in einer ersten isothermen Quellenzone mit hoher Temperatur aufnimmt, einem zweiten Fach (22; 122; 222), das mindestens ein Substrat (62) in einer zweiten isothermen Niederschlagszone enthält, und einem dritten Fach (23; 123; 223), das eine dritte, einen Wärmeschacht bildende isotherme Zone bildet, wobei Trenngitter (63; 163; 165) einerseits zwischen dem ersten und zweiten Fach (21, 22; 121, 122; 221, 222) und andererseits zwischen dem zweiten und dem dritten Fach (22, 23; 122, 123; 222, 223) angeordnet sind,
dadurch gekennzeichnet, daß das erste, zweite und dritte Fach (21, 22, 23; 121, 122, 123; 221, 222, 223) nicht fluchtend entlang einer gebrochenen Linie angeordnet sind, so daß die Winkelabstände für eine Wärme-Strahlungsentkopplung zwischen dem ersten, zweiten und dritten Fach sorgen (21-23; 121-123; 221-223).

2. Tiegel nach Anspruch 1, dadurch gekennzeichnet, daß er aus einem für Infrarotstrahlen durchlässigen Material wie beispielsweise Quarz besteht und in den Verbindungsbereichen zwischen einerseits dem ersten und dem zweiten Fach (21, 22; 121, 122; 221, 222) und andererseits zwischen dem zweiten und dem dritten Fach (21, 22, 23; 121, 122, 123; 221, 222, 223) ebene Schaulöcher (24, 25; 124, 125) aufweist.

3. Tiegel nach Anspruch 2, dadurch gekennzeichnet, daß die Schaulöcher (24, 25; 124, 125) bezüglich der Achse des zweiten Fachs (22; 122; 222) geneigt sind, so daß ein entlang der Achse des zweiten Fachs (22; 122; 222) ausgerichtetes Bündel polarisierten Beobachtungslichts im Brewsterschen Winkel auf die Schaulöcher (24, 25; 124, 125) fällt.

4. Tiegel nach einem der Ansprüche 1 bis 3, dadurch gekennzeichnet, daß das erste, zweite und dritte Fach (21, 22, 23; 221, 222, 223) in U-förmigem Aufbau angeordnet sind.

5. Tiegel nach Anspruch 4, dadurch gekennzeichnet, daß erstes und drittes Fach (21, 23) quer zum zweiten Fach (22) angeordnet sind.

6. Tiegel nach Anspruch 4, dadurch gekennzeichnet, daß erstes und drittes Fach (221, 223) mit dem zweiten Fach (222) jeweils einen stumpfen Winkel und somit einen U-förmigen Aufbau mit zwei unterschiedlichen Zweigen bildet.

7. Tiegel nach einem der Ansprüche 1 bis 3, dadurch gekennzeichnet, daß das erste, zweite und dritte Fach (121, 122, 123) in Z-förmigem Aufbau angeordnet sind.

8. Tiegel nach einem der Ansprüche 1 bis 7, dadurch gekennzeichnet, daß er einen rechteckigen Querschnitt aufweist.

9. Tiegel nach einem der Ansprüche 1 bis 7, dadurch gekennzeichnet, daß er einen trapezförmigen Querschnitt aufweist.

10. Tiegel nach einem der Ansprüche 1 und 4 bis 7, dadurch gekennzeichnet, daß er einen kreisförmigen Querschnitt aufweist.

11. Apparat zum Abscheiden aus der Gasphase bei hoher Temperatur mit einem thermisch isolierenden Behälter (6), einem ersten, zweiten und dritten Diffusor (3, 4, 5), um eine erste, zweite und dritte Zone zum isothermen Erwärmen jeweils um das erste, zweite und dritte Fach (21, 22, 23; 121-123; 221-223) eines geschlossenen, wegnehmbaren Tiegels (1) herum zu bilden, der zur Aufnahme eines Quellenmaterials (64; 164) in dem ersten Fach (21; 121; 221) und eines Substrats (62) im zweiten Fach (22; 122; 222) bestimmt ist, dadurch gekennzeichnet, daß der erste, zweite und dritte Diffusor (3, 4, 5) durch ihren Aufbau thermisch voneinander unabhängig sind und jeweils einen U-förmigen Querschnitt aufweisen, um jeweils das erste, zweite und dritte Fach (21, 22, 23; 121, 122, 123; 221, 222, 223) des Tiegels zu umschließen, sowie dadurch, daß dieses erste, zweite und dritte Fach (21-23; 121-123; 221-223) nicht fluchtend entlang einer gebrochenen Linie angeordnet sind, so daß die Winkelabstände für eine Wärme-Strahlungsentkopplung zwischen dem ersten, zweiten und dritten Fach sorgen (21-23; 121-123; 221-223).

12. Apparat nach Anspruch 11, dadurch gekennzeichnet, daß der Tiegel (1) aus einem für Infrarotstrahlen durchlässigen Material wie beispielsweise Quarz besteht, und daß er in den Verbindungsbereichen zwischen einerseits dem ersten und dem zweiten Fach (21, 22; 121, 122; 221, 222) und andererseits zwischen dem zweiten und dem dritten Fach (21, 22, 23; 121, 122, 123; 221, 222, 223) ebene Schaulöcher (24, 25; 124, 125) aufweist, sowie dadurch, daß der Isolierbehälter (6) des Apparats wegnehmbare, thermisch isolierende Verschlüsse (26, 27) aufweist, die gegenüber den ebenen Schaulöchern (24; 25; 124; 125) angeordnet sind, um das selektive Aussenden von Lichtstrahlen entlang der Achse des zweiten Fachs (22; 122; 222) des Tiegels (1) zu ermöglichen, damit die Abscheidung in diesem zweiten Fach (22; 122; 222) optisch sichtbar gemacht werden kann.

13. Apparat nach Anspruch 12, dadurch gekennzeichnet, daß die ebenen Schaulöcher (24, 25; 124, 125) bezüglich der Achse des zweiten Fachs (22; 122; 222) derart geneigt sind, daß ein entlang der Achse des zweiten Fachs (22; 122; 222) ausgerichtetes Bündel polarisierten Beobachtungslichts im Brewsterschen Winkel auf die Schaulöcher (24, 25; 124, 125) fällt.

14. Apparat nach einem der Ansprüche 11 bis 13, dadurch gekennzeichnet, daß der Isolierbehälter (6) eine Falltür (9) aufweist, die im wesentlichen entlang der größten Abmessung des zweiten Fachs (22; 122; 222) des Tiegels (1) ausgerichtet und in eine im wesentlichen transversale Richtung bezüglich der Achse dieses zweiten Fachs beweglich ist, um ein Befüllen und Entleeren des Tiegels (1) sicherzustellen.

15. Apparat nach einem der Ansprüche 11 bis 14, dadurch gekennzeichnet, daß der erste, zweite und dritte Diffusor (3, 4, 5) jeweils mittels kleiner Isoliersäulen (56) auf einem gemeinsamen Sockel (37) befestigt sind.

16. Apparat nach einem der Ansprüche 11 bis 15, dadurch gekennzeichnet, daß zumindest der zweite Diffusor (4) Wärmeleitrohre (54, 55) aufweist, um die Isothermie der diesem Diffusor (4) entsprechenden Zone entlang der Achse des zweiten Fachs (22; 122; 222) des Tiegels (1) zu gewährleisten.

17. Apparat nach einem der Ansprüche 11 bis 16, dadurch gekennzeichnet, daß das erste, zweite und dritte Fach (21-23; 221-223) des Tiegels (1) und daß der erste, zweite und dritte Diffusor (3, 4, 5) in U-förmigem Aufbau angeordnet sind.

18. Apparat nach Anspruch 17, dadurch gekennzeichnet, daß der Tiegel (1) eine rechteckige Form hat, und daß der erste, zweite und dritte Diffusor (3, 4, 5) mit U-förmigem Querschnitt mindestens eine geneigte Innenwand aufweisen, und daß wärmeleitfähige Keile (291, 292) mit dreieckigem Querschnitt zwischen den Tiegel (1) und die geneigten Innenwände der Diffusoren (3, 4, 5) gesetzt sind.

19. Apparat nach Anspruch 17, dadurch gekennzeichnet, daß der Tiegel (1) trapezförmig ist, daß das erste und das dritte Fach (221, 223) mit dem zweiten Fach jeweils einen stumpfen Winkel und somit einen U-förmigen Aufbau mit zwei unterschiedlichen Zweigen bilden, und daß der erste, zweite und dritte Diffusor (3, 4, 5) sich den Formen des Tiegels anpassen und dadurch gleichzeitig einen direkten Wärmekontaktdurch Leitung zwischen dem ersten, zweiten und dritten Diffusor (3, 4, 5) und jeweils dem ersten, zweiten und dritten Fach (221, 222, 223) und eine automatische Zentrierung des Tiegels (1) gewährleisten.

20. Apparat nach einem der Ansprüche 11 bis 16, dadurch gekennzeichnet, daß das erste, zweite und dritte Fach (121-123) des Tiegels (1) sowie der erste, zweite und dritte Diffusor (103, 104, 105) in Z-förmigem Aufbau angeordnet sind.

21. Apparat nach Anspruch 14, dadurch gekennzeichnet, daß er einen Mechanismus zum automatischen Befüllen und Entleeren des Tiegels mit einem senkrechten Lagerkanal (46) für Tiegel (47), einem Schlitten (48) zum Positionieren der Tiegel im senkrechten Lagerkanal (46) und Vorrichtungen (38, 39) zum Bewegen der Falltür (9) aufweist, damit zwischen dem senkrechten Lagerkanal (46) und dem thermisch isolierenden Behälter (6) automatisch ein Tiegel (1) hin- und hertransportiert werden kann.
